# EUROPEAN PATENT SPECIFICATION

(11) **EP 1 894 891 B1**
(45) Date of publication and mention of the grant of the patent: **06.03.2013**
(21) Application number: 07006442.3
(22) Date of filing: 28.03.2007
(51) Int. Cl.: C01G 19/00

(54) **ITO Powder and method for manufacturing same, coating material for electroconductive ITO film, and transparent electroconductive film**
ITO-Pulver und Herstellungsverfahren dafür, Beschichtungsmaterial für einen elektrisch leitenden ITO-Film und transparenter elektrisch leitender Film
Poudre ITO et son procédé de fabrication, matériau de revêtement pour film ITO électroconducteur, et film électroconducteur transparent

(30) Priority: 28.08.2006 JP 2006230635
(43) Date of publication of application: 05.03.2008
(73) Proprietor: DOWA Electronics Materials Co., Ltd., Chiyoda-ku Tokyo 101-0021 (JP)
(72) Inventor: Tanoue, Koji, Tokyo 101-0021 (JP); Konno, Shinichi, Tokyo 101-0021 (JP); Hinotsu, Takashi, Tokyo 101-0021 (JP)
(74) Representative: Grünecker, Kinkeldey, Stockmair & Schwanhäusser

(56) References cited:
- JP-A- 6 080 422
- US-A1- 2003 030 036
- SHU-GUANG CHEN, CHEN-HUI LI, WEI-HAO XIONG, LANG-MING LIU AND HUI WANG: "Preparation of indium-tin oxide (ITO) aciculae by a novel concentration-precipitation and post-calcination method" MATERIALS LETTERS, vol. 58, no. 3-4, 2004, pages 294-298, XP002466683

## Description

### 1. Field of the Invention

The present invention relates to ITO powder for use in the formation of a transparent electroconductive film, a method for manufacturing the ITO powder, a coating material for an electroconductive ITO film containing the ITO powder, and a transparent electroconductive film manufactured using the coating material for an electroconductive ITO film.

### 2. Description of the Related Art

In the present specification, the term "ITO" refers to tin-containing indium hydroxide. Films containing this ITO are electroconductive and highly translucent with respect to visible light, and are therefore used as transparent electrically conductive films in various display devices, solar batteries, and the like. Known methods for forming transparent electrically conductive films using ITO include physical formation methods in which the ITO is formed using sputtering or the like, and coating formation methods in which a film is formed by applying an ITO particle-dispersion liquid or an ITO-containing organic compound.

The ITO-coated film obtained by such a coating formation method has somewhat lower electroconductivity than an ITO film obtained by sputtering or another physical formation method, but does not require the use of a vacuum device or other expensive device during formation and can be used to form large surface areas and complex shapes. As a result, ITO-coated films obtained by coating formation methods provide the benefit of a lower cost.

Furthermore, among coated film-formation methods, methods using an ITO particle-dispersion liquid as the coating material do not require the coated film to be thermally decomposed, and therefore are able to form a film in a relatively low-temperature process and yield better electroconductivity than methods using an ITO-containing organic compound as the coating material. Methods in which the ITO-coated film is obtained by coating the ITO particle-dispersion liquid are therefore widely used as the method for forming electromagnetic wave shield films for cathode-ray tubes, and are being investigated for applications in LCDs, ELs, and other display devices.

The shape and composition of ITO particles used in an ITO particle-dispersion liquid shall be further described. Conventionally, the ITO particles used in ITO particle-dispersion liquids have generally been granular in shape. However, in the past several years, the use of ITO particles having an acicular shape (also called a rod shape), a tabular shape, or another shape has been proposed in order to further reduce resistance in the film and in order to increase contact between particles when an electroconductive path is formed (for example, see Japanese Patent No. 3241066)

US-A-2003/0030036 discloses a process for preparing an ITO powder, comprising the steps of baking a tin containing indium hydroxide in a tubular furnace at 600°C in a nitrogen atmosphere containing water vapour and ammonia gas for two hours. The obtained acicular ITO particles have a major axis Lₘₐₓ of 500 nm or les, a minor axis Lₘᵢₙ of 100 nm or less and a ratio (Lₘₐₓ/Lₘᵢₙ) of 1.5 - 10. The resistance values of a film comprising said ITO powder is relatively high. JP-A-06080422 also discloses a method to obtain acicular hydrates of tin oxide and indium oxide, but also in that case the resistance values of a film made with the grains is higher than with the grains obtained with the present invention as described below.

### SUMMARY OF THE INVENTION

Methods for obtaining an ITO-coated film by applying an ITO particle-dispersion liquid have many benefits, as described above. However, stability-related problems are presented in that the resistance value of ITO powder containing ITO particles used in an ITO particle-dispersion liquid dramatically changes over time, and in that the degree to which the resistance value changes over time varies depending on the surrounding environment. For this reason, in the prior art, the ITO powder preferably is prevented from coming into contact with oxygen and water as much as possible while being handled. However, installing equipment that does not allow mass-produced ITO powder to come into contact with oxygen or water is costly, and therefore unrealistic.

In view of the foregoing circumstances, it is an object of the present invention to provide ITO powder containing ITO particles that are highly stable in air, whose resistance value changes little over time, and that have a low resistance value; a method for manufacturing the ITO powder; a coating material for an electroconductive ITO film containing the ITO powder; and a transparent electroconductive film manufactured using the coating material for an electrically conductive ITO film.

In order to resolve the aforedescribed problems, the present inventors investigated the mechanisms causing a change over time in air of the resistance values of the ITO particle-containing ITO powder, of the coating material for an electroconductive ITO film containing the ITO powder, and of the transparent electroconductive films manufactured using the coating material for an electroconductive ITO film.
Generally, a resistance of the electroconductive ITO film manufactured by using the coating material for the electroconductive ITO film occurs from substantially two factors. First factor is a carrier electron density in the ITO, and a second factor is a resistance generated when the carrier electrons move in the electroconductive film, i.e. a resistance generated when the carrier electrons move between the ITO particles.

First, the present inventors investigated the first source of resistance.
The composition of the ITO particles had an effect on the electroconductivity of the ITO-coated film. Two mechanisms are involved in the generation of electroconductivity in the ITO particles. The first mechanism is the substitution of the In³⁺ of the ITO crystals contained within the ITO particles with Sn⁴⁺. The substitution causes one free electron to be generated for each Sn atom, which imparts electroconductivity to the ITO particles. The second mechanism is the making of oxygen loss in the ITO crystals contained within the ITO particles. This creates two free electrons for each oxygen loss, which imparts electroconductivity to the ITO particles.

The ITO particles are endowed with Sn⁴⁺ and oxygen loss, and the density of free electrons, which are carriers, is increased in order to make the ITO-coated film electrically conductive and to further increase electroconductivity. However, the present inventors discovered that this contributed to changes over time in the stability and resistance value of the oxygen-loss-imparted ITO powder when the powder was exposed to air. In other words, the oxygen-depleted ITO powder and the oxygen in the atmosphere recombine, and a reaction that reduces oxygen loss proceeds, resulting in instability and changes over time. The present inventors have discovered that recombination with oxygen proceeds most in the ITO particles after the ITO powder containing the ITO particles have been manufactured when the ITO powder is first exposed to air or another oxygen-containing atmosphere.

Therefore, based on these findings, the present inventors discovered a wholly revolutionary technique in which a baked ITO powder is brought into contact with water in a precontrolled state, whereupon an amount of water controlled to a set range is adsorbed onto the ITO particles contained within the ITO powder, whereby the surfaces of the ITO particles are stabilized.

The present inventors next investigated the second cause of resistance. As a result of the investigation, the present inventors discovered that the second cause of resistance resulted from insufficient contacting surface area between ITO particles, the presence of impurities at interfaces between ITO particles, differences in crystal orientation at the contacting surfaces of ITO particles, and other factors. The present inventors found that increasing the contacting surface area between ITO particles is an effective way to reduce the impact of the second cause of resistance.

Increasing the contacting surface areas between the ITO particles shall be further described.
ITO particles according to the prior art that have relatively high resistance and that are used in CRT electromagnetic shields and the like usually have a spherical or bulk shape. ITO particles according to conventional technology have spherical shapes that are highly curved on all sides and only offer point contact at locations where particles make contact with one another. Therefore, the present inventors have discovered that portions of ITO particles that are in contact with one another should have a shape that has as little curvature as possible. Even more preferably, when acicular particles or particles having another anisotropic shape are coated onto an object, the ITO particles are expected to be oriented in the coating direction. Therefore, the orientations of the ITO crystals contained within the ITO particles are also substantially lined up.

In other words, in order to solve the aforementioned problem, a first aspect of the present invention provides ITO powder that adsorbs 0.01 wt% or greater and 2.0 wt% or less of water and contains ITO particles having a major axis that is 1000 nm or less in length and a minor axis that is 100 nm or less in length; wherein
the major axis/minor axis value, which is the ratio of the,major and minor axes, is greater than 1 and less than or equal to 10.

A second aspect of the present invention provides the ITO powder of the first aspect, wherein the length of the major axis is 700 nm or less and 100 nm or greater, and the length of the minor axis is 100 nm or less and 30 nm or greater.

A third aspect of the present invention provides the ITO powder of the first or second aspect, wherein a chemically adsorbed water content of the adsorbed water is 0.01 wt% or greater and 1.0 wt% or less.

A fourth aspect of the present invention provides the ITO powder of any of the first through third aspects, wherein b* of the color of the powder has a value of that is less than zero and -15 or greater in the L*a*b* color space.

A fifth aspect of the present invention provides a method for manufacturing ITO powder baking tin-containing indium hydroxide in a mixed atmosphere of an inert gas and a reducing gas, and obtaining a baked tin-containing indium material; and
bringing the baked tin-containing indium material into contact for a predetermined period of time with a water-containing gas at a temperature that is at or below the baking temperature, so that the water is adsorbed.

A sixth aspect of the present invention provides a method for manufacturing ITO powder including the stems of:
baking tin-containing indium hydroxide in a mixed atmosphere of an inert gas and a reducing gas, and obtaining a baked tin-containing indium hydroxide material;
bringing the baked tin-containing indium hydroxide material into contact for a predetermined amount of time with a water-containing inert gas and/or water-containing reducing gas at a temperature of 0°C or greater and 100°C or less, so that the water is adsorbed; and
exposing, to ambient air, the baked tin-containing indium hydroxide material onto which water has been adsorbed.

A seventh aspect of the present invention provides a coating for an electroconductive ITO film, wherein the ITO powder of any of the first through fourth aspects is used.

An eighth aspect of the present invention provides a transparent electroconductive film manufactured using the coating material for an electroconductive ITO film of the seventh aspect.

The ITO powder according to the present invention is highly stable in air, has a resistance value that changes little over time, and has a low resistance value.

### DESCRIPTION OF THE PREFERRED EMBODIMENTS

Preferred embodiments for implementing the present invention shall be described below.
ITO particles contained within the ITO powder according to the present embodiment contain water. The amount of water contained within the ITO particles is 0.01 wt% or greater and 2.0 wt% or less.

When the water contained within the ITO particles is the total adsorbed water, the adsorbed water can be thought of as being divided into physically adsorbed water and chemically adsorbed water. Physically adsorbed water and chemically adsorbed water shall be described below. First, the term "physically adsorbed water" refers to water that is removed from the surfaces of the particles when the ITO powder is heated from room temperature to 100°C. The term "chemically adsorbed water" refers to water that is removed from the surfaces of the particles when the ITO powder is heated in a range from 100°C to 300°C. The former is present in the surfaces of the particles in a physically adsorbed state while the latter is present in a first layer of the surfaces of the particles in a bonded or chemically adsorbed state. The water content of the ITO particles according to the present invention is preferably such that the amount of chemically adsorbed water is 0.01 wt% or greater and 1.00 wt% or less.

A discussion of the configuration of the ITO powder follows hereunder. The ITO powder according to the present embodiment contains a plurality of acicular ITO particles. Major axes of the ITO particles according to the present embodiment are preferably 1000 nm or less. This is because particles having a large major axis consequently also tend to have a large minor axis. The size of the minor axes is preferably 100 nm or less. The light-permeability of the ITO particles will be maintained, and the light-permeability of a transparent electroconductive film formed using the ITO particles will be preferably maintained as long as the size of the minor axis is 100 nm or less. The shape and size of the ITO particles according to the present embodiment are substantially determined by the shape and size of tin-containing indium hydroxide, which is an intermediate product.

Ideally, the acicular ITO particles in the ITO film according to the present embodiment are oriented so that the major axes of the particles are matched in direction to the flow of electrons, and are disposed so that the direction of the permeation of light and the direction of the minor axes of the particles are the same. On the other hand, the number of interfaces between the ITO particles is proportional to the reciprocal of the length of the major axes of the particles. Therefore, as the length of the major axes increases, the number of interfaces decreases and resistance to electricity decreases.

Disposing the acicular ITO particles in the ITO film so that the direction of light permeation matches the direction of the minor axes of the particles will allow light to pass between minor axial parts of the ITO particles, and therefore minimizes scattering. In general, the effect of the powder on light passing therethrough will increase when the particle diameter of the powder is half the wavelength of the penetrating light, and will decrease proportionally to the power of six when the particle diameter is smaller than half the wavelength. For this reason, the particle diameter of the ITO particles is preferably smaller than half the 400 nm wavelength of a visible light region in order to reduce the amount of light scattered by the ITO particles according to the present embodiment. Therefore, a particle diameter of 200 nm or less, and more preferably of 100 nm or less, is desired for the ITO particles in the direction of light permeation, i.e., the direction of the minor axes.

Therefore, the ITO particles of the present embodiment are desirably shaped so as to have as long a major axis as possible and to be as short as possible in the direction of the minor axis. However, in practice, the ITO crystals in coated ITO particles are oriented in a substantially uniform fashion, but are not entirely arranged in a single direction. Particles may overlap or the direction of the major axes of the particles may be perpendicular to the surface of the coated film. For this reason, the density of the surface of the coated film decreases as the major axes of the particles increases. In particular, a marked decrease in density will occur when the major axes are 1000 nm or greater. Therefore, an upper limit of 1000 nm, and more preferably of 700 nm, is placed on the length of the major axes.

A description shall be provided in regard to the major axis/minor axis ratio (may be referred to below as the "axial ratio"), which is the ratio of the major and minor axes of the ITO particles according to the present embodiment. Improvements in the balance of electroconductivity and light permeation in the ITO particles according to the present embodiment can be anticipated as long as the axial ratio is at least greater than one. ITO particles having an axial ratio of approximately one are not readily oriented during coating. The axial ratio is therefore preferably two or greater in actual use. High axial ratio values are also preferable in that the ITO particles will be readily oriented during the application of a coating material for an electroconductive ITO film containing the ITO particles. However, in order to make the axial ratio seven or greater, merely increasing the reaction temperature in a process for producing tin-containing indium hydroxide (described hereafter) will not be sufficient. The reaction time must also be increased. Therefore, in terms of productivity, the axial ratio is preferably in a range of three to ten, and is more preferably in a range of five to seven.

The ITO powder containing the plurality of acicular ITO particles according to the present embodiment is produced substantially through (A) a step in which a tin salt and an indium salt are mixed at a predetermined ratio, water is added, a neutralizer is added, and the resulting mixture is neutralized to yield acicular tin-containing indium hydroxide particles; (B) a step in which the resulting acicular tin-containing indium hydroxide particles are baked at a temperature of 250°C or greater and 1000°C or less to yield ITO particles; and (C) a step in which a predetermined amount of water is allowed to be adsorbed onto the ITO particles. The step defined in (B) is performed under a reducing atmosphere in order to endow the ITO particles with oxygen loss.

First, examples of processes for manufacturing the acicular tin-containing indium hydroxide according to step (A) shall be described.
(1) In a least complicated method, ammonia or another alkali can be slowly neutralized in and combined with a mixed solution of indium chloride and tin chloride. A high temperature during the neutralization reaction will result in large particles having a high axial ratio. A low temperature during the neutralization reaction will result in small particles having a low axial ratio.
(2) The same process is performed as in (1), except that an initial stage of the neutralization process is performed at a low temperature, hydroxide nuclei are first formed, the temperature is then raised, and the hydroxide nuclei are allowed to grow under a high temperature, whereby a hydroxide having a high axial ratio can be obtained.
(3) ITO hydroxide microparticles or other nanoparticles are dispersed as seed crystals in a solvent, an indium salt and an alkali are added to the solvent, and a hydroxide having a high axial ratio is allowed to grow epitaxially.
The conditions that govern the particle shape of the acicular ITO particles differ in each of the aforedescribed manufacturing methods (1), (2), and (3). Examples of such conditions include the reaction temperature, neutralization speed, and reaction concentration.

An example of the process for baking the acicular tin-containing indium hydroxide according to step (B) shall next be described.
The ITO particles according to the present embodiment are manufactured by baking the tin-containing indium hydroxide precursors manufactured, e.g., by the manufacturing process of (1), (2), or (3). In the baking process, water is removed from the tin-containing indium hydroxide, and the ITO crystals created by removing water from the hydroxide are endowed with oxygen loss. After the baking process, the ITO powder containing a plurality of acicular ITO particles according to the present embodiment is brought into contact with water in the aforedescribed manner, cooled to about room temperature, removed from the air, and broken apart or otherwise processed to create the end product.

When the ITO particles are spherical, water can be removed from the hydroxide at the same time that the hydroxide is imparted with an oxygen loss. However, when the ITO particles are acicular, simultaneously removing water from the hydroxide and making the hydroxide oxygen-deficient becomes difficult. First, in the baking process (1), the hydroxide is baked in an ambient air atmosphere at a temperature from 250°C to 500°C mainly to remove water from the ITO. In the baking process (2), baking is performed in an ambient air atmosphere, an active gas atmosphere, or an oxygen atmosphere at a temperature from 500 to 1000°C mainly to advance crystallization in the ITO. In the baking process (3), baking is performed in a reducing atmosphere at a temperature from 150 to 500°C mainly to impart the ITO particles with oxygen loss. The baking processes are thus distinctly separated into three processes, making it possible to obtain acicular ITO particles that have high axial ratios and in which little sintering occurs between particles.

On the other hand, grain boundaries that are tens of nanometers in size and small holes generated when water is removed from the acicular ITO particles are observed within each of the resulting acicular ITO particles. These grain boundaries and water-removal holes hinder the movement of electrons and are therefore preferably kept to a minimum.

A BET value (specific surface area) of the resulting acicular ITO particles is mainly determined by the size of the particles and the amount of water-removal holes. As described above, the amount of water-removal holes is preferably kept to minimum. Therefore, the BET value of the resulting acicular ITO particles is preferably near a BET value theoretically calculated from the particle size of the ITO particles. The amount of water-removal holes created is determined by the below-described temperature during the baking process.

The stabilization treatment (4) according to the process (C) in which a predetermined amount of water is adsorbed onto the resulting ITO particles shall be further described.
The resulting acicular ITO particles are imparted with an oxygen loss and are therefore extremely active toward oxygen. For this reason, it is believed that the ITO particles are preferably prevented from coming into contact with oxygen-containing air as much as possible. However, in terms of practicality, during handling and other times, the ITO particles are not readily completely prevented from coming into contact with oxygen-containing air.

Therefore, the present inventors have discovered that changes over time in the electrical conductivity of the acicular ITO particles after being exposed to air can be minimized by forming a film of water in a controlled state on surfaces of the baked acicular ITO particles. The film of adsorbed water is preferably formed after the acicular ITO particles have been manufactured and first before the particles are exposed to an oxygen-containing atmosphere. The total amount of adsorbed water formed on the surface of the acicular ITO particles is preferably 0.01 wt% or greater and 2.0 wt% or less for the powder overall. A water film can be formed that sufficiently covers the surfaces of the acicular ITO particles and the effect of minimizing changes over time in electroconductivity can sufficiently be produced as long as the total amount of adsorbed water is 0.01 wt% or greater. An upper limit for the total amount of adsorbed water is 2.0 wt%. The effects will already be maximized even if the total amount of adsorbed water is increased beyond 2.0 wt%. According to the investigations of the present inventors, the total amount of adsorbed water is more preferably 0.01 wt% or greater and 1.0 wt% or less.

When the total amount of adsorbed water is considered as being divided into the above-described physically adsorbed water content and chemically adsorbed water content, the main contributor to control over changes over time in electroconductivity due to the formation of the film of water on the surfaces of the ITO particles is believed to be the chemically adsorbed water content. Because the chemically adsorbed water is first adsorbed onto the surfaces of the ITO particles, a preferred lower limit for the chemically adsorbed water content is 0.01 wt%, which is the same as the lower limit for the total adsorbed water content. An upper limit for the amount of chemically adsorbed water is 1.0 wt%. The effect will already be maximized even if the amount of chemically adsorbed water is further increased beyond 1.0 wt%.

The mechanism for the adsorption of water is as follows. First, water molecules are chemically adsorbed onto a first layer of the surfaces of the ITO particles to become chemically adsorbed water. The chemically adsorbed water molecules in the first layer are securely held to the surfaces of the ITO particles by chemical interaction with the surface of the particles and by a dipole moment between the water molecules and the electric fields of the surfaces of the ITO particles. In a second layer and below, the bond is weak at interfaces between the water molecules and the ITO particles, and the water becomes physically adsorbed water. Water removed at temperatures from room temperature to 100°C is believed to be the weakly bonded physically adsorbed water of the second layer and below. Water removed at temperatures of 100 to 300°C is believed to be the chemically adsorbed water centered in the first layer.

As in the ITO particles of the present embodiment, nanoparticles having a specific surface area of about 10 m²/g or greater are highly active because a ratio of the number of atoms present at the surface to the number of atoms constituting the entire nanoparticle is high. Extremely high activity in the surface of ITO particles intentionally imparted with oxygen loss can readily be expected.
When water molecules are adsorbed onto the surfaces of such extremely highly active ITO particles, the stability of the ITO particles while in air increases because water molecules securely bond with unbound electrons present in the surfaces of the ITO particles and function as a barrier against instances of oxygen being absorbed and oxygen loss being reduced.

A total adsorbed water content including the above-described chemically adsorbed water content will result in the ITO powder of the present embodiment having extremely small particles that have major axes of 1000 nm or less, and in the ITO powder having minimal reactivity toward oxygen regardless of the fact that the powder has been imparted with oxygen loss. As a result, the powder will be more readily handled, and will have improved stability in air. Consequently, ITO powder can be obtained whose resistance value changes little over time when the powder is exposed to air

The color tone and electroconductivity of the ITO powder obtained through the steps (A) through (C) shall next be described.
In the ITO powder of the present embodiment, to which a predetermined amount of water has been adsorbed, and which has been subjected to a stabilization treatment, when the transmission color for the visible light region is expressed in the L*a*b* color space established by the CIE (International Committee on Illumination), the b* value, which indicates the level of blue, is -15 or greater and less than 0 even after being exposed to air. The resistance value of a compacted powder formed at one t/cm² was 0.1 Ωcm or less. The b* value depends on the amount of oxygen loss. If the value is 0 or less, sufficient oxygen loss has been maintained in the ITO particles contained within the ITO powder, and favorable electroconductivity will be produced. Specifically, in ITO powder having a value of 0 or less, the resistance value of powder compacted at one t/cm² was 0.1 Ωcm or less. In addition, when the b* value of the ITO powder was -4 or less, the resistance value of the compacted powder was 0.03 Qcm or less.

In contrast, when ITO powder not subjected to the process (C) was exposed to air after the above-described baking process (B), there was a partial decrease in oxygen loss, and electroconductivity decreased. When such decreases in oxygen loss occurred, the b* value increased in the positive direction.
On the other hand, when the acicular ITO powder is endowed with excessive oxygen loss, black insulating InO forms, the L* value decreases (the color darkens), and electroconductivity also decreases.

### (Method for manufacturing the ITO powder of the present embodiment)

A method for manufacturing the ITO powder according to the present embodiment shall be described below.
First, in a first step, a tin salt and indium salt are weighed out and mixed, the mixture is dissolved in purified water to form a tin salt and indium salt mixed solution, the mixed solution and an alkali are reacted, and a slurry of tin hydroxide and indium hydroxide is formed.
A method in which the alkali is added to a tin salt and indium salt mixed water solution is preferably used as the mixing method. When the alkali is added to the tin salt and indium salt mixed water solution, acicular particles are readily formed, and the size and axial ratio of the resulting hydroxide particles can be controlled by controlling the temperature, addition rate, and particle concentration while the alkali is being added.

Examples of tin and indium salts include hydrochloride, sulfate, and nitrate salts. However, in general, hydrochloride salts are preferable. Ammonia, sodium hydroxide, potassium hydroxide, and carbonates thereof can be used for the alkali. However, ammonium is preferably used in order to eliminate impurities after the slurry of tin hydroxide and indium hydroxide is formed.

The resulting slurry of tin hydroxide and indium hydroxide is collected by solid-liquid separation, and impurities are rinsed away using purified water to yield a highly pure tin-containing indium hydroxide cake. The resulting cake is dried at a temperature at or above room temperature, and preferably 80°C or greater, to yield dry tin-containing indium hydroxide powder.

In the tin-containing indium hydroxide, the tin may be (1) substituted with indium of the indium hydroxide, but may also be (2) coprecipitated with the indium hydroxide as tin oxide and/or tin hydroxide, or (3) formed into a noncrystalline mixture with the indium hydroxide as tin oxide and/or tin hydroxide.

As described above, the particle diameter of the tin-containing indium hydroxide is determined by the process for obtaining the hydroxide. Specifically, tin-containing indium hydroxide having a predetermined particle diameter can be obtained by controlling conditions so that the reaction temperature is 10°C to 100°C, the reaction time (time required for total neutralization) is ten minutes to 12 hours, and the final particle concentration is 0.01 mol/L to 0.5 mol/L.
For example, when acicular tin-containing indium hydroxide particles having major axes of 930 nm and minor axes of 130 nm are synthesized, the reaction temperature should be 90°C, the reaction time (time required for total neutralization) should be 60 minutes, and the final particle concentration should be 0.1 mol/L. On the other hand, when particles are to be manufactured that have smaller major axes than the acicular tin-containing indium hydroxide particles, the reaction temperature should be lowered, the reaction rate should be lowered, or the particle concentration should be increased.
The final size of the resulting ITO particles is substantially determined by the size of the tin-containing hydroxide. In other words, when the tin-containing hydroxide is changed into ITO particles, the major axes and minor axes both contract about 70 to 80%.

A process for baking the resulting tin-containing indium hydroxide, which is a second process, shall next be described.
The baking process is used (1) to form ITO, which is an oxide, from the tin-containing indium oxide, and (2) to impart the crystals of the resulting ITO with oxygen loss. Therefore, the baking process is performed under a weak reducing atmosphere of mixed inert gas and reducing gas in order to impart the ITO crystals with oxygen loss. A mixture gas composed of hydrogen, carbon monoxide, and ammonia gas mixed into nitrogen, helium, argon, or another inert gas is used for the weak reducing atmosphere. The mixing ratio of the gases in the mixture gas is suitably determined by the amount of oxygen loss with which the ITO crystals are to be imparted. If the reducing power of the mixture gas is too high, the tin-containing indium hydroxide will become InO, metallic In, or the like. In addition, the mixture ratio of the hydrogen, carbon monoxide, and the like is preferably intended to yield a concentration at which the mixture gas does not exceed an explosive limit in ambient air.

The baking process includes the baking processes (1) through (3) and the stabilization treatment process (4). These processes shall be described below in sequence.
The baking process (1) is a process for removing water from the tin-containing indium hydroxide to form indium oxide. The baking temperature is 250°C or greater and 500°C or less. A complete oxide can be obtained as long as the temperature is 250°C or greater, and severe sintering between ITO particles can be avoided as long as the temperature is 500°C or less. The baking temperature is preferably 250°C or greater and 450°C or less. Baking should be performed for 0.1 hour or more. The baking time need not exceed 0.1 hour if the water removal reaction is complete.

The baking process (2) is a process for increasing crystallization in the indium oxide. The baking temperature is 500°C or greater and 1000°C or less, and preferably 500°C or greater and 800°C or less. The baking time is 0.1 hour or greater and ten hours or less, and is preferably 0.5 hour or greater and five hours or less. The atmosphere is selected from one or more of an ambient air atmosphere, an inert gas atmosphere, and/or an oxygen gas atmosphere.
The baking process (1) and the baking process (2) are distinctly separated, whereby acicular ITO powder having a high axial ratio and little sintering can be obtained.

As described above, the BET value (specific surface area) of the ITO particles is determined mainly by the size of the particles and the amount of water-removal holes formed when the water is removed. The amount of water-removal holes is preferably kept to a minimum. Therefore, the measured BET value of the ITO particles is preferably near a BET value theoretically calculated from the particle size of the ITO particles. The amount of water-removal holes is determined by the temperature in the baking process (2). Therefore, in consideration of the amount of water-removal holes, the temperature in the baking step (2) is 500°C or greater and 1000°C or less, and preferably 500°C or greater and 800°C or less. The baking time is 0.1 hour or greater and ten hours or less, and preferably 0.5 hour or greater and five hours or less.

The baking process (3) is performed under a reducing atmosphere at a temperature that is at least lower than that used in the baking process (2), and is preferably 150°C or greater and less than 500°C. The particles can be imparted with oxygen loss as long as the baking temperature is 150°C or greater. A favorable reductive force can be obtained, and, therefore, insulating InO will not form as long as the baking temperature is less than 500°C. The baking time is 0.1 hour or greater and ten hours or less, and is preferably 0.5 hour or greater and five hours or less. The atmosphere is preferably a weak reducing atmosphere.
After the baking process (3), the atmosphere is changed to a weak reducing atmosphere or an inert gas atmosphere and cooled to substantially normal temperature.

In the stabilization treatment process (4), water is adsorbed onto the ITO particles obtained in the baking process (3), and a stabilization treatment is performed. In the stabilization treatment process, the ITO powder containing the baked ITO particles is exposed for a predetermined time (specifically, preferably from one minute to one hour) to a water-containing inert gas and/or a reducing gas at a temperature equal to or less than that of the baking temperature in (3) (specifically, preferably 0°C or greater and 100°C or less), and water is adsorbed to the surfaces of the ITO particles.

The amount of water adsorbed onto ITO particles in the stabilization treatment process (4) is proportional to the relative humidity of the atmosphere and the exposure time, as long as the particles are equal. On the other hand, the amount of water adsorbed onto the ITO particles quickly reaches an equilibrium. Therefore, the water content of the particles is believed to be the same as an average value for the water content of the powder.

### (Example of method for manufacturing a coating liquid using the ITO powder of the present embodiment)

The ITO powder of the present embodiment is dispersed in a liquid medium using a dispersing agent and thereby made into a liquid or paste-form dispersing material and formed into a coating material. A well-known method can be used for the method for forming the coating material. An alcohol, ketone, ether, ester, or other organic solvent or water can be used as the liquid medium. A surfactant, coupling agent, or the like may be used for the dispersing agent. A binder may be used as desired. When used, the binder is preferably an epoxy resin, acrylic resin, vinyl chloride resin, polyurethane resin, polyvinyl alcohol resin, or the like; however, the selection is not limited thereto. When the ITO powder according to the present invention is dispersed in the liquid medium, a bead mill or another dispersing device is preferably used to perform the dispersing.
The coating liquid using the ITO powder of the present embodiment can be applied on a substrate, which is a simple and low-cost means, to readily produce a transparent electroconductive coated film having exceptional characteristics such as high stability in air and a resistance value that changes little over time.

### (Method for manufacturing a coated film using the coating liquid that contains the ITO powder of the present embodiment)

Screen printing spin coating, dip coating, roll coating, brush coating, spray coating, or another well-known method can be used when the coating liquid, which is a liquid or paste-form dispersing material containing the ITO powder of the present embodiment, is applied or formed into a coated film. However, screen printing, spin coating, and the like are preferably used in order to arrange the particles. For example, when the dispersing material is applied on a substrate, organic polymers, plastic, glass, and the like can be used for the substrate material, and a film-form substrate is generally used. In particular, polymer films are preferably used in substrates such as electron paper and touch panels that require flexibility. Films made from polyethylene terephthalate (PET), polyethylene naphthalate (PEN), polyimides, aramids, polycarbonates or other materials can be used for the polymer film.
The resulting coated film containing the ITO powder of the present embodiment is a transparent electroconductive coated film having exceptional characteristics such as high stability in air and a resistance value that changes little over time.

### [Examples]

### (Example 1)

203 g of indium chloride water solution (InCl₃) having an indium concentration of 18.5 wt% and 5.6 g of tin chloride (SnCl₄ 5H₂O) were weighed and dispersed in purified water to form 2.9 L of an indium chloride and tin chloride mixed solution. The tin concentration in the mixed solution was 5 mol% of the sum total of indium and tin.
A NaOH water solution having a NaOH concentration of 10 wt% was prepared and added to the indium chloride and tin chloride mixed solution. The NaOH was added in an amount 1.2 times the amount necessary to neutralize the InCl₃ and SnCl₄. Specifically, the NaOH water solution was added over a span of 60 minutes while the temperature of the indium chloride and tin chloride mixed solution was held at 90°C to form a tin-containing indium hydroxide suspension liquid. The resulting tin-containing indium hydroxide suspension liquid was percolated, collected, and then rinsed by purified water to yield a tin-containing indium hydroxide cake. The tin-containing indium hydroxide cake was dried at 100°C. The resulting tin-containing indium hydroxide had a major axis of 900 nm and a minor axis of 130 nm.

The tin-containing indium hydroxide was placed in a baking furnace and baked under an ambient air atmosphere at a temperature of 250°C for two hours. The tin-containing indium hydroxide was then baked under a N₂ atmosphere at a temperature of 800°C for one hour, and was then further baked under a N₂ atmosphere having a H₂ concentration of one vol% at a temperature of 250°C. The tin-containing indium hydroxide was then brought into contact for 50 minutes with an N₂ atmosphere having a relative humidity of 80% while the temperature was held.
This caused both the major axis and minor axis of the tin-containing indium hydroxide to contract about 75%. The resulting ITO powder had a major axis of 700 nm, a minor axis of 100 nm, and an axial ratio of 7.0. The BET value (specific surface area) was 8 m²/g. These values are shown in Table 1 along with the results of measurements of the adsorbed water content, color difference, and resistance value.

The methods for measuring these properties shall be described below.
Specific surface area: obtained by a BET1 point method using a Monosorb measuring device (Quantachrome Instruments).
Adsorbed water content: measured using a CA-100 measuring device (Mitsubishi Chemical Corporation). The amount is determined by a coulometric titration method using a Karl Fischer reaction.
These devices were used as described below to measure total adsorbed water content, physically adsorbed water content, and chemically adsorbed water content.
First, an ITO sample was placed into a test tube of the device and heated. Once a predetermined temperature was reached, the predetermined temperature was held until the rate at which water from the ITO sample was generated became 0.1 pg/sec or less, and the amount of removed water was determined by a titration cell unit. The water desorbed at temperatures from room temperature to the predetermined temperature of 100°C was the physically adsorbed water content. The water desorbed from room temperature to a predetermined temperature of 300°C was the total adsorbed water content. The difference between the total adsorbed water content and the physically adsorbed water content; i.e., the difference between the total adsorbed water content desorbed at the predetermined temperature of 300°C and the physically adsorbed water content desorbed at the predetermined temperature of 100°C, was calculated and used as the chemically adsorbed water content. The weight of the test sample used in the measurements is described in Table 1 along with the results of the measurements.
Color difference: light reflected from the powder was measured using a color difference meter Z-300A (Nippon Denshoku Co., Ltd.).
Measurement of the resistance value of compacted powder: the ITO powder was subjected to a pressure of one t/cm², and a columnar plate having a diameter of 25 mm was produced. The electric resistance value of the plate was measured by a four-probe method. A Loresta HP (Mitsubishi Chemical Corporation) was used for the measuring device.
Particle diameter: a method for measuring the particle diameter of the ITO particles shall be described.
Measurement of the particle diameters of the ITO particles was performed by preparing a TEM photograph of the ITO particles, making actual measurements of the major axes and minor axes of the particles in the TEM photograph using a micrometer caliper, converting the magnification ratio of the measured values, and obtaining average values thereof. The axial ratio was calculated by dividing the major axis by the minor axis. A higher number of measured ITO particles is preferably used, and at least about 100 are preferably measured. ITO particles where the particle boundaries were not clear were not included in the measurements.

### (1) Measurements of the ITO powder directly after baking

After being baked, the ITO powder was removed from the furnace under N₂ and immediately transported into a glove box filled with N₂. The ITO particles were broken down within the glove box using a mill and then formed into a plate. The resistance of compacted powder was then measured.

### (2) Measurement of the ITO powder after being exposed to air for two hours

After being baked, the ITO powder was removed from the furnace, exposed to air for two hours, and transported to a glove box filled with N₂. The ITO powder was broken down in the glove box using a mill and then formed into a plate. The resistance of compacted powder was then immediately measured. The ambient air atmosphere used during exposure had a relative humidity of 10 to 20% and a temperature of 20°C ± 5°C.

Assessment of coated film: 5 g of the ITO powder after being exposed to air for two hours, 20 g of a mixed solution (ethanol/propanol ratio: 7:3), and 0.25 g of an anionic surfactant as a dispersing material were placed in a ball mill (P-5; Fritsch Co.; capacity: 80 mL, balls: PSZ 0.3 mm), and spun at a rate of 300 rpm for 30 minutes. An acrylic resin binder was added to the mixture in an amount of 5 wt% of the ITO powder to produce a coating material, 2% of which was composed of ITO powder and the remainder of which was composed of ethanol, propanol, and acrylic resin. The resulting coating material was applied on a polyethylene film using a coater having a 1-µm slit to form a coated film. The coated film was dried at 80°C, and then calendered at an inter-roller pressure of 200 kg/cm. The electric resistance value of the coated film was measured by a four-probe method. A Loresta HP (Mitsubishi Chemical Corporation) was used for the measuring device. An NDH 2000 (haze meter/turbidimeter; Nippon Denshoku Industries Co., Ltd.) was used to measure light transmission of the coated film.

### (Examples 2, 3)

The same operation was performed as in Example 1, except that in the step for combining the tin-containing indium hydroxide cake, the molar ratio of the added tin was changed to 10 mol% to manufacture an ITO powder according to an Example 2, and the molar ratio of the added tin was changed to 15 mol% to manufacture an ITO powder according to an Example 3. The BET values (specific surface areas) of the resulting ITO powders of Examples 2, 3 were both 8 m²/g. The BET values as well as results of measurements of the axial length, axial ratio, adsorbed water content, color change, and resistance value are shown in Table 1.

### (Examples 4 through 6)

The same operation was performed as in Example 1, except that in the step for combining the tin-containing indium hydroxide cake, the neutralizing temperature was changed to 70°C to manufacture a tin-containing indium hydroxide cake according to an Example 4, the neutralizing temperature was changed to 40°C to manufacture a tin-containing indium hydroxide cake according to an Example 5, and the neutralizing temperature was changed to 30°C to manufacture a tin-containing indium hydroxide cake according to an Example 6. The baking temperature for the tin-containing indium hydroxide was changed to 700°C in Example 4, 650°C in Example 5, and 600°C in Example 6 to manufacture ITO powders according to the Examples 4 through 6.
Results of measurements of the axial length, axial ratio, BET value (specific surface area), adsorbed water content, color difference, and resistance value of the resulting ITO powders are shown in Table 1.

### (Examples 7, 8)

The same operation was performed as in Example 4, except that the conditions while the water was being adsorbed were changed to a N₂ atmosphere having a relative humidity of 80% for a treatment time of 30 minutes in an Example 7, and were changed to an N₂ atmosphere having a relative humidity of 80% for a treatment time of ten minutes in an Example 8 to manufacture ITO powders according to the Examples 7, 8. Results of measurements of the axial length, axial ratio, BET value (specific surface area), adsorbed water content, color difference, and resistance value of the resulting ITO powders are shown in Table 1.

### (Comparative Examples 1 through 4)

The same operation was performed as in Examples 1, 4, 5, 6 except that the water adsorption treatment was not performed. ITO powders according to Comparative Examples 1, 2, 3, 4 were manufactured.
Results of measurements of the axial length, axial ratio, BET value (specific surface area), adsorbed water content, color difference, and resistance value of the resulting ITO powders according to Comparative Examples 1 through 4 are shown in Table 1.

### (Comparative Example 5)

203 g of an indium chloride water solution (InCl₃) having an indium concentration of 18.5 wt% and 5.6 g of tin chloride (SnCl₄ 5H₂O) were weighed and then dissolved in purified water to produce 2.9 L of an indium chloride and tin chloride mixed solution. The tin concentration in the mixed solution was 5 mol% of the sum total of the indium and tin.
A NaOH water solution having a concentration of 10 wt% was prepared and added to the indium chloride and tin chloride mixed solution. The NaOH was added in an amount 1.2 times the amount needed to neutralize the InCl₃ and SnCl₄. Specifically, the NaOH water solution was added over a span of three minutes while the temperature of the indium chloride and tin chloride mixed solution was held, and a tin-containing indium hydroxide suspension liquid was formed.
The resulting tin-containing indium hydroxide suspension liquid was percolated, collected, and then rinsed by purified water to yield a tin-containing indium hydroxide cake. The tin-containing indium hydroxide cake was dried at a temperature of 100°C. The resulting tin-containing indium hydroxide had an undetermined amorphous shape.

The tin-containing indium hydroxide was placed in a baking furnace and baked under an ambient air atmosphere at a temperature of 250°C for two hours. The tin-containing indium hydroxide was then baked under a N₂ atmosphere at a temperature of 750°C for two hours and further baked under a N₂ atmosphere having an H₂ concentration of one vol% at a temperature of 250°C. The tin-containing indium hydroxide was then brought into contact with an N₂ atmosphere having a relative humidity of 80% for 50 minutes while the temperature was held constant, and an ITO powder according to a Comparative Example 5 was manufactured.

The BET value (specific surface area) of the resulting ITO powder was 20 m²/g. The particles had a spherical shape that is well-known in the prior art. The particle diameter was 40 nm and the axial ratio was 1.0. These values as well as results of measurements of the adsorbed water content, color difference, and resistance value are shown in Table 1.

### (Comparative Example 6)

The same operation was performed as in Example 1, except the addition time for the NaOH was changed to two hours to yield acicular ITO hydroxide having a major axis of 1300 nm and a minor axis of 200 nm, and an ITO powder according to a Comparative Example 6 was obtained.
Results of measurements of the axial lengths, axial ratio, BET value (specific surface area), adsorbed water content, color difference, and resistance value of the resulting ITO powder are shown in Table 1.

### (Summary of Examples 1 through 8 and Comparative Examples 1 through 6)

As can be concluded from the results shown in Table 1, each of the ITO powders according to Examples 1 through 8 that contain the ITO particles that have adsorbed water had a total adsorbed water content in a range of 0.01 wt% or greater and 2.0 wt% or less, and had a chemically adsorbed water content in a range of 0.01 wt% or greater and 1.0 wt% or less. The resistance values and powder color of compressed powder of the ITO particle-containing ITO powders according to Examples 1 through 6 where determined to be substantially unchanged before and after the powders were exposed to air for two hours. From these results, it was determined that the ITO powder according to Examples 1 through 6 are stable in air and have resistance values that change little over time when the powder is exposed to air.

On the other hand, each of the ITO particle-containing ITO powders according to Comparative Examples 1 through 4 had a total adsorbed water content in a range of 0.01 wt% or less and a chemically adsorbed water content in a range of 0.01 wt% or less. Furthermore, the initial resistance values of the ITO powder-containing ITO powders according to Comparative Examples 1 through 4 before being exposed to air were the same as those of Examples 1 through 8. However, after being exposed to air for two hours, the resistance value of the compacted powders increased and the b* color value of the powders increased, resulting in powders that had a yellow hue. From these results, it can be determined that the ITO powders according to Comparative Example 1 through 4 are not stable in air, and a marked change occurs in the resistance value of the powders over time when the powders are exposed to air.

In a comparison of Examples 1, 4 through 8 and Comparative Example 6, the coated film having the acicular powder resulted in a lower resistance value than the spherical powder. However, when large particles having a major axis exceeding 1000 nm were formed, the minor axis also increased to 150 nm. Therefore, light transmission was reduced to 90% and the resistance value increased to 2500 Ω/square.
The present invention was described above on the basis of the embodiment and examples. However, the present invention is no limited thereto.

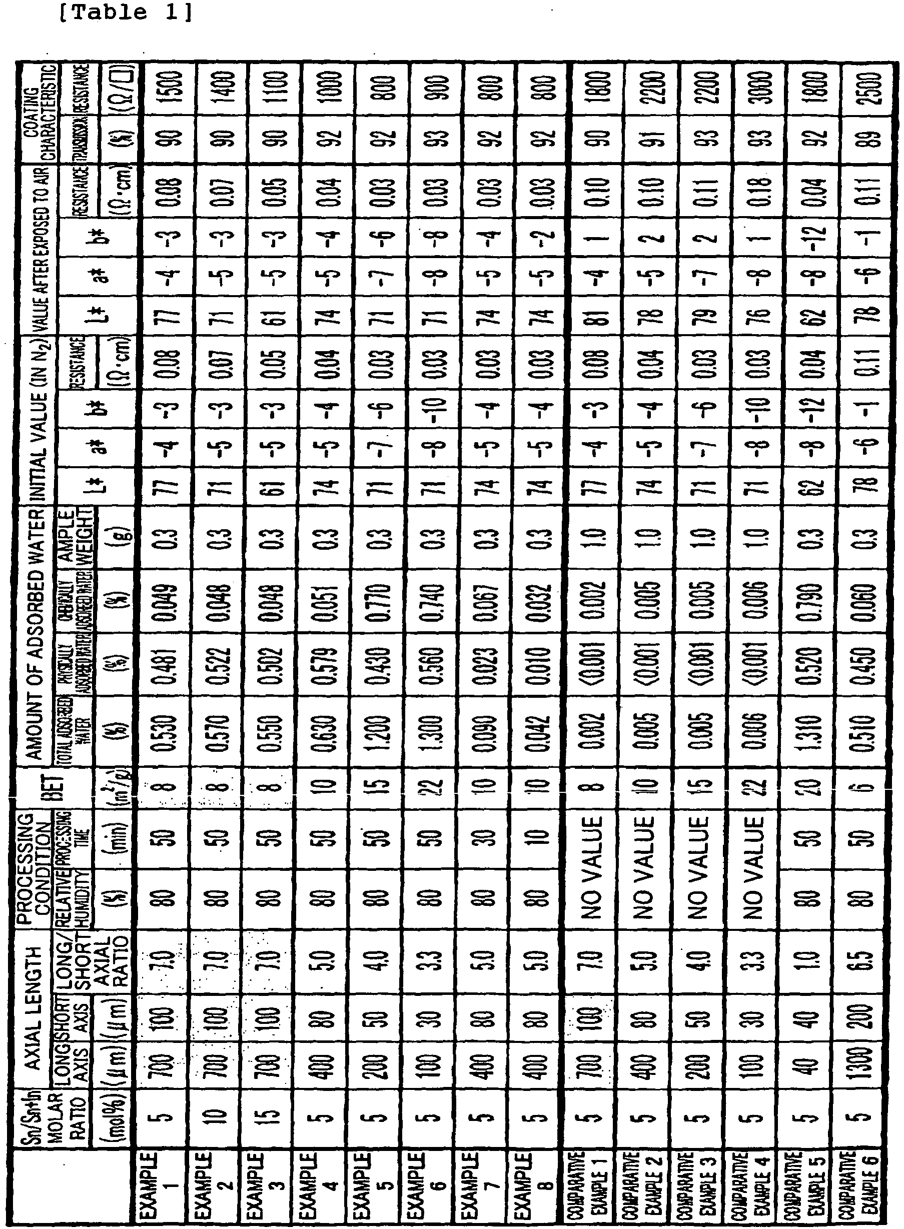

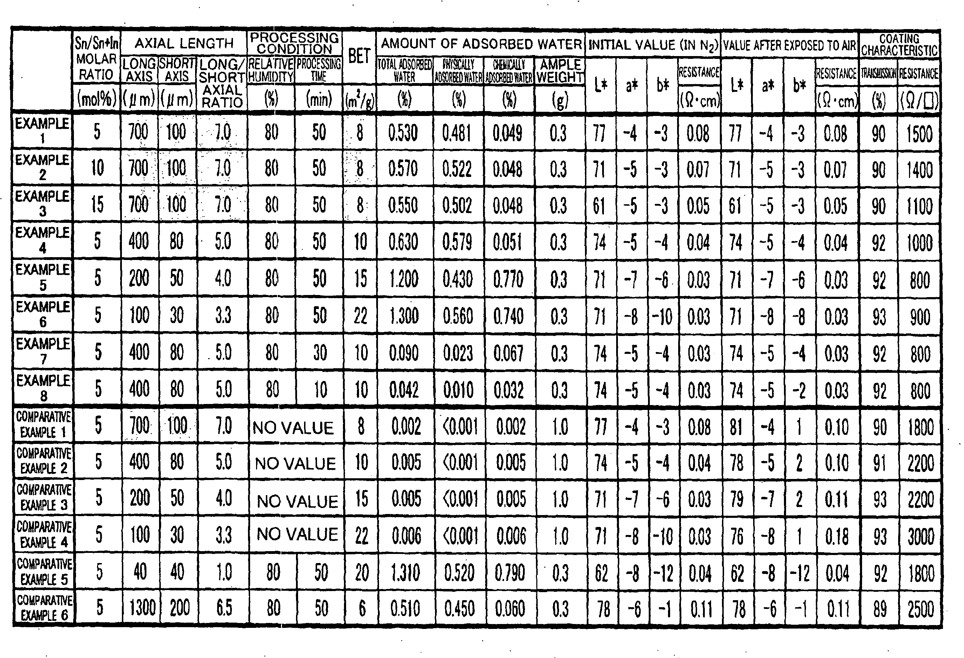

## Claims

1. An ITO powder that contains ITO particles having a major axis that is 1000 nm or less in length and a minor axis that is 100 nm or less in length, wherein
the major axis/minor axis value, which is the ratio of said major and minor axes, is greater than 1 and less than or equal to 10
**characterized in that**
the ITO powder adsorbs 0.01 wt% or greater and 2.0 wt% or less of water.

2. The ITO powder of claim 1, wherein the length of said major axis is 700 nm or less and 100 nm or greater, and the length of said minor axis is 100 nm or less and 30 nm or greater.

3. The ITO powder of claim 1 or 2, wherein a chemically adsorbed water content of said adsorbed water is 0.01 wt% or greater and 1.0 wt% or less.

4. The ITO powder of any of claims 1 through 3, wherein the b* color value of the powder is less than zero and -15 or greater in an L*a*b* color space.

5. A method for manufacturing ITO powder including the step of:
baking tin-containing indium hydroxide in a mixed atmosphere of an inert gas and a reducing gas, and obtaining a baked tin-containing indium material;,
**characterized by**
bringing said baked tin-containing indium material into contact for a predetermined period of time with a water-containing gas at a temperature that is at or below said baking temperature, so that the water is adsorbed.

6. The method of claim 5,
wherein said water-containing gas is a water-containing inert gas and/or water-containing reducing gas, and
said temperature is a temperature of 0°C or greater and 100°C or less,
said method further including a step of exposing, to ambient air, said baked tin-containing indium hydroxide material onto which water has been adsorbed.

7. A coating for an electroconductive ITO film, wherein the ITO powder of any of claims 1 through 4 is used.

8. A transparent electroconductive film manufactured using the coating material for said electroconductive ITO film of claim 7.

## Patentansprüche

1. ITO-Pulver, das ITO-Partikel enthält, die eine Hauptachse, die 1.000 nm oder weniger lang ist, und eine Nebenachse haben, die 100 nm oder weniger lang ist, wobei
der Wert Hauptachse/Nebenachse, der das Verhältnis von Hauptachse zu Nebenachse ausdrückt, größer als 1 und kleiner oder gleich 10 ist,
**dadurch gekennzeichnet, dass**
das ITO-Pulver 0,01 Gew.-% oder mehr und 2,0 Gew.-% oder weniger Wasser adsorbiert.

2. ITO-Pulver nach Anspruch 1, bei dem die Länge der Hauptachse 700 nm oder weniger und 100 nm oder mehr beträgt und die Länge der Nebenachse 100 nm oder weniger und 30 nm oder mehr beträgt.

3. ITO-Pulver nach Anspruch 1 oder 2, bei dem ein chemisch adsorbierter Wassergehalt des adsorbierten Wassers 0,01 Gew.-% oder mehr und 1,0 Gew.-% oder weniger beträgt.

4. ITO-Pulver nach einem der Ansprüche 1 bis 3, bei dem der b*-Farbwert des Pulvers geringer als Null und -15 oder höher in einem L*a*b*-Farbraum ist.

5. Verfahren zum Herstellen eines ITO-Pulvers, das folgenden Schritt umfasst:
Backen von zinnhaltigem Indiumhydroxid in einer gemischten Atmosphäre eines Inertgases und eines Reduktionsgases und Beziehen eines gebackenen, zinnhaltigen Indiummaterials,
**gekennzeichnet durch**
In Berührung bringen des gebackenen zinnhaltigen Indiummaterials mit einem wasserhaltigen Gas für eine vorbestimmte Zeitdauer bei einer Temperatur, die gleich der Backtemperatur ist oder unter dieser liegt, so dass das Wasser adsorbiert wird.

6. Verfahren nach Anspruch 5, bei dem das wasserhaltige Gas ein wasserhaltiges Inertgas und/oder wasserhaltiges Reduktionsgas ist und
die Temperatur eine Temperatur von 0°C oder mehr und 100°C oder weniger ist,
wobei das Verfahren weiterhin den Schritt umfasst, das gebackene, zinnhaltige Indiumhydroxidmaterial, auf dem Wasser adsorbiert wurde, Umgebungsluft auszusetzen.

7. Beschichtung für einen elektrisch leitfähigen ITO-Film, wobei das ITO-Pulver einer der Ansprüche 1 bis 4 verwendet wird.

8. Transparenter, elektrisch leitfähiger Film, der mit Hilfe des Beschichtungsmaterials für den elektrisch leitfähigen ITO-Film nach Anspruch 7 hergestellt ist.

## Revendications

1. Poudre d'ITO qui contient des particules d'ITO présentant un axe majeur qui possède une longueur de 1000 nm ou moins et un axe mineur qui possède une longueur de 100 nm ou moins,
dans laquelle la valeur axe majeur/axe mineur, qui est le rapport desdits axes majeur et mineur, est supérieure à 1 et inférieure ou égale à 10,
laquelle poudre d'ITO est **caractérisée en ce qu'**elle adsorbe 0,01 % en poids ou plus et 2,0 % en poids ou moins d'eau.

2. Poudre d'ITO selon la revendication 1, dans laquelle la longueur dudit axe majeur est de 700 nm ou moins et de 100 nm ou plus, et la longueur dudit axe mineur est de 100 nm ou moins et de 30 nm ou plus.

3. Poudre d'ITO selon la revendication 1 ou 2, dans laquelle la teneur en eau chimiquement adsorbée de ladite eau adsorbée est de 0,01 % en poids ou plus et de 1,0 % en poids ou moins.

4. Poudre d'ITO selon l'une quelconque des revendications 1 à 3, dans laquelle la valeur colorimétrique b* de la poudre est inférieure à zéro et est de -15 ou plus dans l'espace colorimétrique L*a*b*.

5. Procédé pour fabriquer une poudre d'ITO, comprenant l'étape de cuisson d'hydroxyde d'indium contenant de l'étain dans une atmosphère mixte d'un gaz inerte et d'un gaz réducteur, ce qui donne un matériau à base d'indium contenant de l'étain cuit ;
**caractérisé par** la mise en contact dudit matériau à base d'indium contenant de l'étain cuit, pendant une période de temps prédéterminée, avec un gaz contenant de l'eau à une température égale ou inférieure à ladite température de cuisson, de façon que l'eau soit adsorbée.

6. Procédé selon la revendication 5, dans lequel ledit gaz contenant de l'eau est un gaz inerte contenant de l'eau et/ou un gaz réducteur contenant de l'eau, et ladite température est une température de 0°C ou plus et de 100°C ou moins,
ledit procédé comprenant en outre une étape d'exposition à l'air ambiant dudit matériau à base d'hydroxyde d'indium contenant de l'étain cuit sur lequel de l'eau a été adsorbée.

7. Revêtement pour un film d'ITO électriquement conducteur, dans lequel est utilisée la poudre d'ITO de l'une quelconque des revendications 1 à 4.

8. Film transparent électriquement conducteur fabriqué par utilisation du matériau de revêtement pour ledit film d'ITO électriquement conducteur de la revendication 7.
